# FASCICULE DE BREVET EUROPEEN

(11) **EP 2 364 953 B1**
(45) Date de publication et mention de la délivrance du brevet: **10.05.2017**
(21) Numéro de dépôt: 11157318.4
(22) Date de dépôt: 08.03.2011
(51) Int. Cl.: B81C 1/00

(54) **Procédé de fabrication d'un microsystème électromécanique utilisant la gravure d'une couche sacrificielle à travers d'une zone poreuse**
Herstellungsverfahren für ein mikromechanisches Bauelement mit Opferschichtentfernung mittels Eindringung von Ätzmittel durch eine poröse Schicht.
Fabrication process for a microelectromechanical system by etching a sacrificial layer through a porous region.

(30) Priorité: 10.03.2010 FR 1051715
(43) Date de publication de la demande: 14.09.2011
(73) Titulaire: COMMISSARIAT À L'ÉNERGIE ATOMIQUE ET AUX ÉNERGIES ALTERNATIVES, 75015 Paris (FR)
(72) Inventeur: GAILLARD, Frédéric-Xavier, 38500 VOIRON (FR); NEMOUCHI, Fabrice, 38430 MOIRANS (FR)
(74) Mandataire: Decobert, Jean-Pascal

(56) Documents cités:
- US-A1- 2007 298 532
- US-A1- 2010 003 790

## Description

### DOMAINE TECHNIQUE DE L'INVENTION

La présente invention concerne la fabrication de microsystèmes électromécaniques en général et décrit plus particulièrement un procédé permettant la libération des parties mobiles d'un tel microsystème.

### ÉTAT DE LA TECHNIQUE

Depuis les années soixante-dix des microsystèmes électromécaniques sont développés qui voient maintenant leur champ d'application s'étendre considérablement. Essentiellement dérivée de la technologie de fabrication des circuits intégrés et de celle de la microélectronique en général, la réalisation de ces microsystèmes fait appel à toutes les techniques physico chimiques mises au point au cours des cinq décennies qui se sont écoulées depuis que les premiers circuits intégrés ont été fabriqués. Généralement désignés sous l'acronyme de MEMS de l'anglais « micro electromechanical systems », voire de NEMS quand leurs dimensions s'expriment en nanomètres (10⁻⁹ mètre) et non plus en micromètres (10⁻⁶ mètres), les méthodes de fabrication de ces microsystèmes peuvent devoir varier très sensiblement en raison même de la très large gamme d'applications considérée. En particulier, quand il s'agit de réaliser un microsystème incluant des parties mécaniques devant être libres de se mouvoir, comme par exemple dans un accéléromètre qui équipe chaque coussin gonflable de sécurité des voitures automobiles, il faudra prévoir les étapes de fabrication nécessaires à leur libération. Libération qui passe par la dissolution d'une couche sacrificielle englobant les parties mobiles réalisées généralement en silicium, ce matériau, universellement employé depuis l'origine pour la fabrication des circuits intégrés, étant aussi utilisé pour ses excellentes propriétés mécaniques pour la réalisation des MEMS. Basés sur des technologies ayant beaucoup en commun et un même matériau, le silicium, les MEMS peuvent alors s'intégrer avec des circuits logiques, notamment ceux très utilisés du type CMOS, de l'anglais « complementary metal oxide semiconductor », pour réaliser des fonctions hydrides sophistiquées, au cours d'un même processus de fabrication.

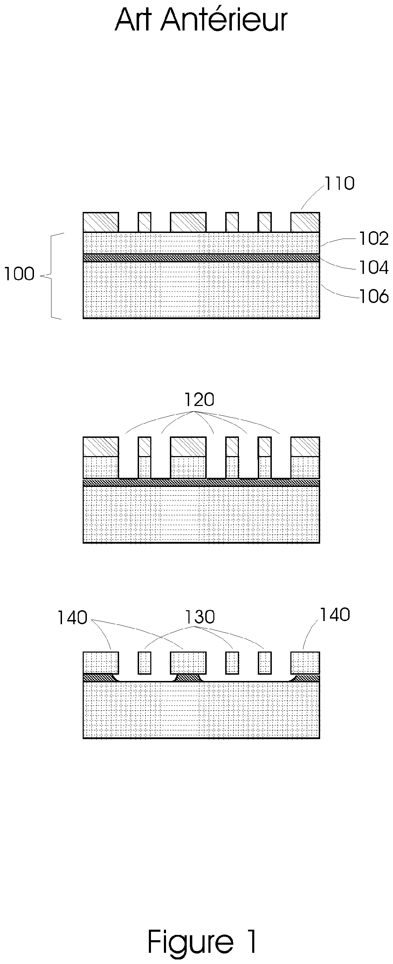

Une méthode bien connue pour réaliser la gravure de MEMS dans un substrat généralement fait de silicium, afin d'en libérer les parties devant être mobiles, fait appel à une technique dite « gravure ionique réactive profonde ». Le plus souvent désignée sous son acronyme de DRIE, de l'anglais « deep reactive ion etching » c'est un procédé de gravure fortement anisotrope qui permet de réaliser des tranchées profondes dans le silicium ayant un rapport hauteur/largeur très élevé. Combiné avec l'utilisation de tranches de silicium élaborées dites SOI (de l'anglais « silicon on insulator ») ce procédé permet la libération des parties mobiles après dissolution de la couche isolante sous jacente 104 comme résumé sur la figure 1. Les tranches SOI 100 sont fabriquées à l'aide un procédé coûteux aboutissant, comme le nom le suggère, à l'obtention d'un matériau de base élaboré comprenant une couche mince de silicium monocristallin 102 dans laquelle les dispositifs à produire sont réalisés, couche mince séparée par un isolant 104, le plus souvent de l'oxyde de silicium (SiO₂), d'un substrat de silicium 106 plus épais conférant à l'ensemble une rigidité mécanique suffisante.

Partant de ce matériau de base, une tranche SOI 100, les parties à libérer et les zones d'ancrage fixes sont définies par les méthodes classiques de photolithographie après dépôt d'une couche de résine photosensible 110. Des tranchées sont ensuite gravées 120 sur toute l'épaisseur de la couche mince monocristalline par DRIE. Après enlèvement de la résine, l'oxyde de silicium est dissout libérant les parties mobiles 130 sans affecter significativement les zones d'ancrage 140 plus larges.

Outre que le matériau de base est coûteux, le procédé brièvement décrit ci-dessus implique que la libération des parties mobiles se fasse à partir de la face supérieure du dispositif. Pour produire des dispositifs hybrides sophistiqués incluant une partie logique importante celle-ci devra avoir été réalisée préalablement sous forme, par exemple, de circuits CMOS dans la couche monocristalline supérieure 102 de la tranche SOI. Se pose alors le problème de la protection de la partie logique, et d'une façon générale des parties du dispositif déjà réalisées de quelque nature qu'elles soient, lors des opérations de gravure des tranchées par DRIE et de libération des parties mobiles par dissolution de l'oxyde de silicium généralement à l'aide d'acide fluorhydrique. Opérations potentiellement très destructrices pour les parties du dispositif hybride déjà réalisées.

Le document US A1 2007/0298532 divulgue un procédé de libération d'un élement du type MEMS dans une couche sacrificielle. Le document US A1 2010/0003790 divulgue un autre procédé. Dans les deux cas, au moins la phase de libération n'est pas optimisée.

C'est donc un objet de l'invention de proposer une nouvelle méthode de libération des parties mobiles d'un dispositif MEMS qui réponde en tout ou partie aux difficultés exposées ci-dessus. En particulier, c'est un objet de l'invention de décrire un procédé qui ne nécessite pas que la libération des parties mobiles d'un dispositif MEMS doive se faire par la face à partir de laquelle les composants, mécaniques et autres, ont été fabriqués.

Un autre objet de l'invention est de proposer une nouvelle structure de dispositif MEMS, en disposant d'un accès fluidique aux parties du MEMS par des zones poreuses. Cet accès peut être employé pour le fonctionnement du MEMS pour le passage de gaz ou de liquides.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

L'invention décrit un procédé de libération des parties mécaniques mobiles d'un microsystème électromécanique selon la revendication 1. Le procédé est caractérisé en ce que une ou des zones poreuses sont formées dans une tranche, préférentiellement sur la face avant d'une première tranche d'un matériau semi-conducteur. Un ou des motifs d'un matériau apte à constituer les parties mécaniques mobiles du microsystème électromécanique sont ensuite formés sur la face avant de la première tranche au droit des zones poreuses. Les motifs sont enrobés dans une couche sacrificielle. Puis, avantageusement, une couche d'un matériau résistant à une attaque par un solvant de la couche sacrificielle est déposée. Un transfert par collage de la face avant de la première tranche sur une deuxième tranche est opéré qui est suivi par un amincissement à partir de la face arrière de la première tranche jusqu'à détection des zones poreuses. La libération des parties mécaniques mobiles est alors effectuée par la face arrière de la première tranche à travers les zones poreuses à l'aide d'un solvant de la couche sacrificielle.

Le procédé peut inclure en outre les caractéristiques optionnelles, alternatives ou accumulatives suivantes :
▪ entre le dépôt de la couche d'un matériau résistant à l'attaque du solvant et la libération de la partie mécanique mobile, on effectue :
   - un transfert par collage de la face avant de la première tranche sur une deuxième tranche;
   - un amincissement à partir de la face arrière de la première tranche jusqu'à détection de la zone poreuse.
▪ la couche sacrificielle couvre au moins partiellement la zone poreuse.
▪ on interrompt la couche sacrificielle par au moins une barrière apte à délimiter au moins partiellement une zone à libérer autour de la partie mécanique mobile, ladite barrière étant faite d'un matériau résistant à une attaque par un solvant de la couche sacrificielle.
▪ la couche sacrificielle est faite d'un oxyde du matériau semi-conducteur constituant la première tranche.
▪ le matériau apte à constituer le motif de la partie mécanique est du silicium monocristallin.
▪ le silicium monocristallin du motif est obtenu par croissance épitaxiale sélective à partir de la première tranche elle-même constituée de silicium monocristallin.
▪ on forme au moins un motif d'oxyde sur la zone poreuse, ledit motif d'oxyde faisant partie de la couche sacrificielle, et on opère la croissance épitaxiale de sorte à recouvrir le motif d'oxyde.
▪ le silicium monocristallin du motif est obtenu par transfert d'une couche épitaxiale formée sur une troisième tranche de silicium monocristallin après formation d'une couche de silicium poreux à sa surface.
▪ un dépôt d'une couche d'oxyde sur la première tranche à l'issue de la formation de la zone poreuse et un dépôt d'oxyde sur la troisième tranche à l'issue de la formation de la couche épitaxiale sont effectués en vue de leur assemblage par collage.
▪ une étape de fracturation de la troisième tranche au niveau de la couche de silicium poreux et une étape de polissage afin de laisser à la surface de la première tranche, une couche continue de silicium monocristallin.
▪ on forme au moins une tranchée remplie d'oxyde au droit de la zone poreuse, suivi par un dépôt d'oxyde sur toute la surface de la première tranche afin de constituer, avec le motif ou la couche d'oxyde préalablement formé sur la zone poreuse, la couche sacrificielle enrobant la partie mécanique mobile.
▪ la réalisation d'au moins un composant électronique du microsystème électromécanique dans la couche de silicium monocristallin.
▪ le matériau apte à constituer le motif de la partie mécanique mobile est du silicium polycristallin.
▪ la réalisation d'étapes de fabrication de composants électroniques participant au microsystème électromécanique au-dessus de la couche d'un matériau résistant à une attaque par un solvant de la couche sacrificielle.
▪ une étape de dépôt sur une face arrière opposée à la face avant de la première tranche d'un matériau apte à rendre étanche le microsystème électromécanique par obstruction de la zone poreuse.
▪ on forme plusieurs zones poreuses et/ ou plusieurs motifs de parties mécaniques mobiles. L'invention décrit également un microsystème électromécanique comprenant des zones poreuses destinées à permettre la libération des parties mécaniques mobiles.

L'invention concerne aussi un dispositif de réalisation d'un microsystème électromécanique selon la revendication 19, comprenant en superposition une tranche d'un matériau semi-conducteur, une couche sacrificielle et une couche d'un matériau résistant à une attaque par un solvant de la couche sacrificielle, et comprenant en outre au moins une partie mécanique mobile au moins partiellement enrobée dans la couche sacrificielle. Il comporte au moins une zone poreuse formée dans la tranche et traversant l'épaisseur de ladite tranche pour permettre un accès fluidique vers la couche sacrificielle.

L'invention décrit également un microsystème électromécanique selon la revendciation 20, comprenant une tranche d'un matériau semi-conducteur et une couche délimitant une chambre de logement d'au moins une partie mécanique mobile. Il comporte au moins une zone poreuse formée dans la tranche et traversant l'épaisseur de ladite tranche pour permettre un accès fluidique vers la chambre.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels des phases successives de procédé sont présentées de haut en bas en colonne de gauche puis de haut en bas en colonne de droite.
La FIGURE 1 illustre une méthode connue de libération des parties mobiles d'un microsystème électromécanique à partir de la surface supérieure du dispositif.
La FIGURE 2 illustre une première façon de mettre en oeuvre l'invention dans laquelle les parties mobiles, réalisées en silicium polycristallin, sont libérées par la face inférieure du dispositif à travers des zones de silicium poreux.
La FIGURE 3 illustre une deuxième façon de mettre en oeuvre l'invention dans laquelle les parties mobiles, réalisées en silicium monocristallin, sont également libérées par la face inférieure du dispositif.
La FIGURE 4 illustre une variante de mise en oeuvre du procédé de l'invention qui permet aussi d'obtenir une couche de silicium monocristallin dans laquelle des dispositifs électroniques et des MEMS peuvent être fabriqués.

Les dessins joints sont donnés à titre d'exemples et ne sont pas limitatifs de l'invention. Des références identiques dans les dessins désignent des opérations où des éléments similaires quelle que soit la figure.

### DESCRIPTION DÉTAILLÉE DE L'INVENTION

La description qui suit est faite dans un contexte de libération complète de plusieurs parties mobiles mais ce cas n'est pas limitatif. Il peut s'agir d'une libération partielle ou encore d'une libération d'une seule partie mécanique. Par ailleurs, le terme partie mobile s'entend de la capacité de ladite partie à être modifiée en position. Cette mobilité s'entend au sens large et peut n'être que partielle, par exemple en libérant une liberté de mouvement uniquement par déformation en flexion sans que la partie soit totalement libre de se mouvoir.

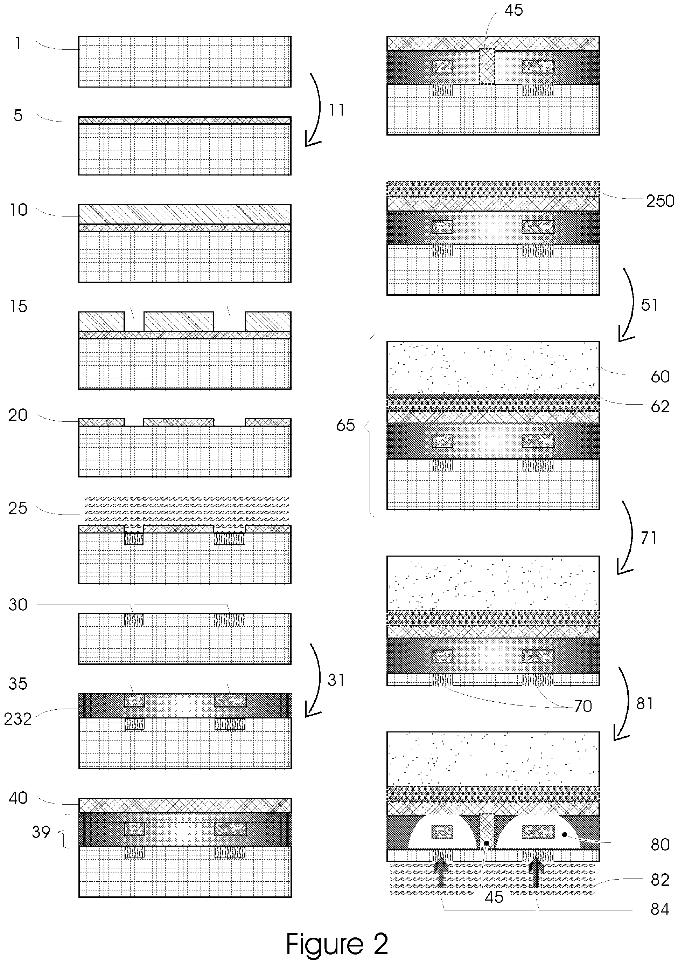

La **figure 2** illustre une première façon de mettre en oeuvre l'invention dans laquelle les parties mobiles sont réalisées en silicium polycristallin.

Le procédé de l'invention utilise comme point de départ le matériau de base de toute l'industrie de la microélectronique c'est-à-dire une tranche homogène de silicium monocristallin 1, généralement faiblement dopé et d'une épaisseur suffisante pour être rigide et facilement manipulable. Tranche souvent désignée sous son vocable anglais de « wafer » et qui constitue le substrat à partir duquel les dispositifs seront fabriqués. A cette fin, la face supérieure de la tranche reçoit généralement un poli de qualité optique. C'est traditionnellement, et uniquement à partir de cette face, que les dispositifs sont réalisés.

On notera que dans toute la description qui suit de l'invention la face supérieure, c'est-à-dire la face de la tranche de départ à partir de laquelle les dispositifs, mécaniques et autres, sont réalisés pourra aussi être désignée comme étant la face avant par opposition à l'autre face de la tranche, désignée comme étant la face inférieure ou face arrière de la tranche de départ.

La première étape 11 du procédé de l'invention consiste à créer des zones de silicium poreux 30 à la surface supérieure de la tranche. Zones qui serviront en fin de procédé à libérer, à travers les pores, les parties mobiles des MEMS situées au droit de ces zones. La porosification du silicium consiste non limitativement à mettre en oeuvre des techniques connues et très brièvement rappelées ci-après.

Depuis les années cinquante on sait obtenir du silicium poreux par voie électrochimique à partir de silicium monocristallin. La porosification est obtenue par dissolution anodique en présence d'acide fluorhydrique (HF). Un appareillage approprié doit être utilisé pour traiter chaque tranche de silicium 1. Les zones à porosifier doivent préalablement être délimitées sur la surface supérieure de la tranche. À cette fin une couche d'un matériau protecteur résistant à la dissolution anodique est d'abord déposée 5. Il s'agit typiquement d'une couche de nitrure de silicium (Si₃N₄). Après dépôt d'une couche de résine photosensible 10, les zones à porosifier sont définies par photolithographie 15 ce qui permet de graver les motifs dans la couche de nitrure 20. Après enlèvement de la résine la surface supérieure de la tranche peut être mise en contact avec un milieu aqueux d'acide fluorhydrique 25 afin de porosifier les zones non protégées par le nitrure de silicium. On impose alors une différence de potentiel ou un courant continue entre une cathode, immergée dans la solution aqueuse d'acide fluorhydrique, et une anode qui est en contact électrique avec la face inférieure de la tranche à porosifier. La concentration en acide fluorhydrique du milieu aqueux, la valeur du courant que l'on impose et le temps d'anodisation sont, entre autres, des paramètres qui permettent de contrôler les caractéristiques de la couche poreuse que l'on désire obtenir. Une illumination du milieu aqueux procure un moyen de contrôle supplémentaire optionnel des caractéristiques de la couche poreuse si nécessaire.

L'épaisseur des zones poreuses à réaliser ainsi que ses caractéristiques pourront être très différentes en fonction d'applications particulières de l'invention. Notamment, la taille des pores produits pourra varier dans une plage étendue de valeurs allant typiquement de quelques nanomètres à quelques micromètres sur une épaisseur comprise, typiquement, entre une centaine de nanomètres et quelques dizaines de micromètres. Après enlèvement du nitrure de silicium qui servait de protection, la tranche de silicium initiale est donc couverte de zones poreuses 30 correspondant aux motifs gravés dans le nitrure et sur une profondeur contrôlée par l'opération de dissolution anodique précédente.

Il est à noter que le terme « zone poreuse » n'est limitatif d'aucune forme, dimension, motif de ladite zone. Par ailleurs, la zone poreuse peut être une couche complète et non seulement des parties d'une couche.

Une fois que les zones poreuses ont été formées la réalisation des microsystèmes se poursuit par l'étape 31 de création des parties mécaniques qui, dans cette première mise en oeuvre de l'invention, sont faites de motifs de silicium polycristallin. Ces motifs 35, alignés sur les zones poreuses et formés sur une première couche d'oxyde 232, sont finalement enrobés complètement dans des couches d'oxyde sacrificielles, formant un tout 39, qui sera dissout pour libérer les parties mobiles comme expliqué ci-après. La façon d'obtenir ces motifs et cette structure verticale met en oeuvre des techniques bien connues de l'homme du métier. En particulier toutes les moyens et techniques pour déposer de l'oxyde de silicium et du silicium polycristallin employés depuis longtemps en microélectronique peuvent s'appliquer. Les motifs peuvent là aussi être définis par les techniques classiques de photolithographie et gravure. L'état de surface notamment entre le premier et le second dépôt d'oxyde pour former l'ensemble 39 pourra nécessiter un polissage, par exemple du type mécano chimique ou CMP (de l'anglais « chemical-mechanical polishing ») pour retrouver la planéité nécessaire afin de pouvoir continuer la fabrication des dispositifs dans des conditions optimales.

Optionnellement, une couche d'un matériau résistant à la solution chimique destinée à dissoudre l'oxyde de silicium enrobant les parties mobiles est ensuite déposée 40. Typiquement, comme déjà mentionné, la solution pour dissoudre l'oxyde de silicium est à base d'acide fluorhydrique et la couche de protection 40 du nitrure de silicium. Si cette couche n'est pas présente l'étape de libération des parties mobiles, décrite plus loin, se fera alors « au temps » c'est-à-dire sur la base de la vitesse d'attaque connue du solvant de la couche sacrificielle.

Optionnellement, une zone d'arrêt verticale pour limiter horizontalement la libération des parties mobiles pourra aussi être créée 45. A nouveau, toutes les techniques connues de l'homme du métier pour créer des tranchées qui devront être comblées avec un matériau protecteur qui peut être le même que celui utilisé pour la couche 40 sont susceptibles d'être utilisées. D'une façon générale l'invention ne requiert pas qu'une méthode particulière soit mise en oeuvre pour obtenir la structure décrite en figure 2.

L'invention ne fait pas non plus d'hypothèses sur le type de dispositifs qui pourra être produit avec cette première mise en oeuvre basée sur l'utilisation de silicium polycristallin pour les parties mécaniques. Des couches supplémentaires 250 de matériaux divers utilisés par l'industrie de la microélectronique pourront avoir à être déposées dont les motifs seront définis comme précédemment par lithographie et gravure.

A ce stade, à l'issue de l'étape 51, la tranche initiale de silicium contenant tous les dispositifs, incluant les MEMS, est transférée sur un second support 60 pour permettre la libération des parties mobiles. Ce second support ne nécessite que d'avoir les qualités mécaniques nécessaires pour la manipulation des tranches et permettre le collage sur la face supérieure de la première tranche, celle dans laquelle les dispositifs ont été réalisés. La fixation du second support se fait à l'aide de méthodes et de techniques connues permettant d'empiler des tranches dans lesquels les circuits sont partiellement ou entièrement fabriqués. Notamment, le second support pourra être une autre tranche de silicium du même type que la première 1 et on pourra faire appel à une technique de collage par adhésion moléculaire oxyde sur oxyde à basse température. Ce type de fixation pourra nécessiter le dépôt préalable d'une couche protectrice pour les dispositifs ou parties de dispositifs déjà fabriqués à la surface de la première tranche et une préparation de la surface des tranches à assembler 62. L'invention ne requiert cependant pas que le second support 60 soit d'une nature particulière, son rôle étant essentiellement de constituer un support mécanique et une protection pour les opérations suivantes.

Le résultat est un assemblage 65 des deux tranches. La première des tranches est alors amincie à partir de la surface inférieure jusqu'à atteindre la face arrière 70 des zones de silicium poreux 30. L'étape d'amincissement 71 se fait en utilisant les techniques connues de l'homme du métier. L'amincissement pourra notamment être conduit en deux sous étapes. Un retrait rapide de silicium est d'abord effectué qui doit pouvoir garantir cependant que les zones poreuses ne soient en aucun cas touchées. Par exemple, la majeure partie du silicium peut être retirée par abrasion mécanique ou par voie chimique. Dans une seconde sous étape, on procède alors à un polissage du type CMP, déjà mentionné plus haut, qui permet de retrouver un état de surface et une planéité satisfaisants pour les opérations suivantes. L'arrêt du polissage peut être contrôlé automatiquement à l'aide de différents moyens connus à détection des zones poreuses, notamment par des moyens optiques, en mesurant la réflexion/absorption d'une source lumineuse sur la surface en cours de polissage. Elle varie en effet rapidement quand les zones poreuses émergent.

L'étape suivante 81 consiste à libérer les parties mobiles en dissolvant l'oxyde de silicium de la couche sacrificielle qui les entoure 80. Ceci est fait 84 à travers les zones de silicium poreux qui ont été préalablement formées à la surface de la première tranche 30 et qui sont devenues accessibles par la face inférieure à l'issue de l'opération d'amincissement de la première tranche. L'attaque de la couche sacrificielle sera optionnellement arrêtée par la couche d'arrêt 40 et par la zone d'arrêt 45 si l'une ou l'autre, ou les deux, sont présentes. Sinon l'arrêt se fera « au temps » sur la base de la connaissance de la vitesse d'attaque de la couche sacrificielle par le solvant.

La solution chimique d'attaque 82 de la couche sacrificielle dépend du matériau utilisé. Dans le cas standard décrit précédemment, utilisant l'oxyde de silicium (SiO₂), une solution d'acide fluorhydrique (HF) peut être utilisée en phase liquide ou gazeuse. Les solutions aqueuses peuvent être par exemple de type HF pur à différents niveaux de concentration cependant. Elles peuvent être aussi composées d'un mélange avec du fluorure d'ammonium (NH₄F). Des solutions chimiques prêtes à l'emploi sont commercialement disponibles comme par exemple de l'acide fluorhydrique dilué à 49% qui peut être aussi dilué plus avant par l'utilisateur pour contrôler la concentration finale, typiquement entre 0.1% et 49%. Des solutions tamponnées type BOE, de l'anglais « buffered oxide etchant », sont aussi disponibles. Elles sont en fait des mélanges de type NH₄F/HF. Des solutions à base de NH₄F uniquement peuvent être aussi considérées. Toutes ces solutions présentent des caractéristiques de vitesses d'attaque des oxydes de silicium qui peuvent être très différentes et dépendantes aussi du type d'oxyde constituant la couche sacrificielle : oxyde thermique ou oxyde de silicium déposé de type USG, de l'anglais « Undoped Silicate Glass » déposé par voie chimique en phase vapeur à partir d'un précurseur : le silane ; ou encore oxyde déposé de type TEOS pour « tetra ethyl ortho silicate ».

L'impact possible sur les autres matériaux, métalliques ou semiconducteurs, constituant les dispositifs à fabriquer doit également être considéré pour choisir la solution chimique d'attaque de la couche sacrificielle. Le contrôle de l'arrêt de la gravure visant à libérer les parties mobiles des MEMS et donc la détermination des temps d'attaque est à l'évidence un paramètre clé qui conditionne la mise en oeuvre du procédé selon l'invention. A titre d'exemples, une vitesse d'attaque d'oxyde de type SiO₂ thermique formé à une température de 1100°C de l'ordre de 620 Å/min (1 Å = 10⁻¹⁰ mètre) peut être observée pour une solution de type BOE correspondant à un mélange NH₄F 40% et HF 49% dans une proportion de sept volumes de NH₄F pour un volume de HF. Une vitesse d'attaque supérieure de l'ordre de 1200 à 2000 Å/min peut être constatée pour un oxyde de type USG ou TEOS déposé par voie chimique en phase vapeur. Ainsi, pour une couche d'oxyde de silicium de 1 micron déposée en phase vapeur, environ 10 min sont nécessaires pour la dissoudre. La couche sacrificielle pourra aussi être dissoute en plusieurs étapes en utilisant successivement différentes solutions de gravure, liquides ou gazeuses.

De façon simple, le contrôle de l'arrêt de gravure se fera en fonction du temps estimé connaissant d'une part, l'épaisseur de la couche sacrificielle ainsi que le matériau utilisé et, d'autre part, la vitesse d'attaque de la solution chimique employée. Dans l'exemple standard ci-dessus d'une couche sacrificielle en oxyde de silicium, l'attaque de ce dernier se fait de façon isotrope à partir de l'ouverture définie par le silicium poreux comme représenté au repère 80 en figure 2.

Comme déjà mentionné ci-dessus, des étapes technologiques supplémentaires peuvent être ajoutées au procédé pour réaliser des barrières 45 (une seule est représentée) empêchant l'attaque chimique de se propager horizontalement assurant ainsi un meilleur contrôle et une plus grande liberté pour la mise en oeuvre de l'étape de libération des parties mobiles. En plus du nitrure de silicium (Si₃N₄) mentionné précédemment, des matériaux du type carbure de silicium amorphe hydrogéné (SiC) et carbonitrure de silicium amorphe hydrogéné (SiCN) sont bien connus pour résister à une attaque HF destinée à dissoudre l'oxyde de silicium autour des parties mobiles. Ils peuvent servir pour réaliser les barrières 45.

On notera par ailleurs qu'une fois la libération des parties mobiles achevée, l'étanchéité des dispositifs sera facilement assurée en déposant par exemple une couche d'oxyde sur la face inférieure de l'assemblage afin de fermer toutes les zones poreuses.

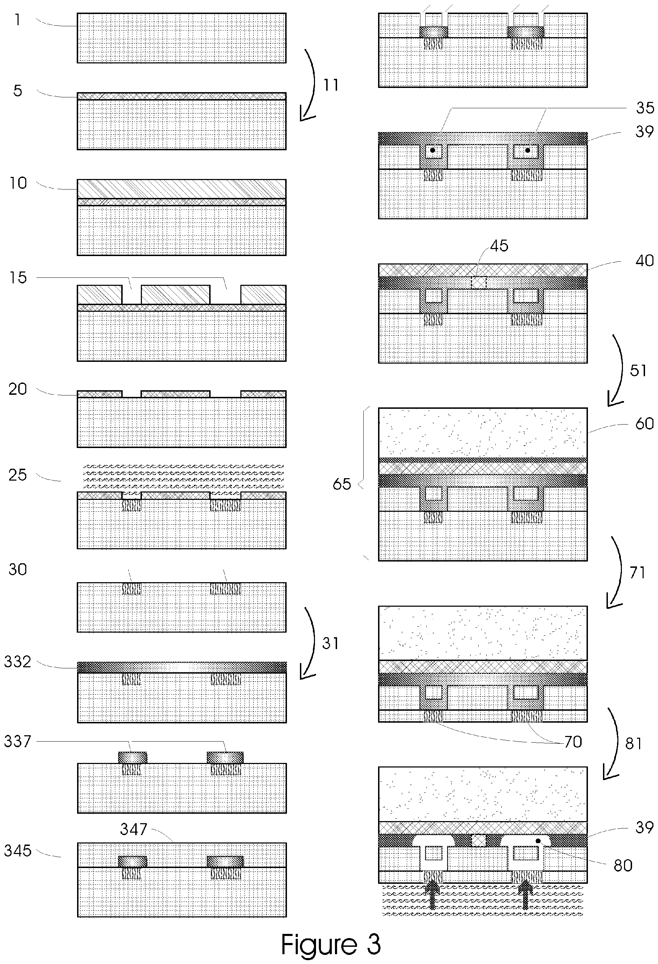

La **figure 3** illustre une deuxième façon de mettre en oeuvre l'invention dans laquelle les parties mobiles, réalisées cette fois en silicium monocristallin, sont également libérées par la face inférieure du dispositif.

L'étape initiale 11 du procédé qui conduit à la formation de zones poreuses 30 à la surface de la première tranche est rigoureusement identique à celle de la figure 2. Les étapes intermédiaires ne sont pas autrement décrites. Elles ne sont reprises ici que par commodité pour afficher dans une même figure toutes les étapes de cette deuxième mise en oeuvre de l'invention.

L'étape suivante 31 permet, comme en figure 2, la création des parties mécaniques. Elle diffère en ce qu'elle consiste d'abord en la formation à la surface de la première tranche 1 d'une couche de silicium monocristallin dans laquelle des composants électroniques pourront être fabriqués pour réaliser, avantageusement, en même temps que des dispositifs MEMS, notamment des circuits logiques ou analogiques. Par exemple, des transistors à effet de champ complémentaires pour des circuits logiques de type CMOS. Dans cette deuxième mise en oeuvre de l'invention, les parties mécaniques sont donc avantageusement aussi réalisées en silicium monocristallin.

A cette fin une couche d'oxyde de silicium 332 est déposée sur toute la surface de la première tranche. Des motifs situés au droit des zones poreuses y sont gravés 337 avec les méthodes traditionnelles employées en micro électronique (dépôt de résine photosensible, photolithographie, gravure de l'oxyde, enlèvement de la résine). C'est sur ces motifs d'oxyde que seront formées comme expliqué ci-après, les parties mobiles des MEMS. Ils constituent la première partie de la couche sacrificielle qui sera finalement dissoute pour libérer les parties mobiles comme décrit précédemment.

Ensuite, par épitaxie, on forme une couche de silicium monocristallin 345 à partir des zones non protégées par l'oxyde. La couche épitaxiale a la même structure cristalline que celle de la tranche sur laquelle elle est formée. L'épitaxie est ici effectuée d'une façon dite sélective. Il n'y a pas croissance de silicium sur les motifs d'oxyde eux-mêmes qui sont cependant finalement recouverts par le silicium monocristallin en raison de la croissance latérale qui s'opère à partir des zones adjacentes. Les techniques pour obtenir ce résultat sont connues de l'homme du métier. Notamment, une technique dite ELO (de l'anglais « epitaxy lateral overgrowth ») peut être employée. Un polissage, du type CMP, peut être nécessaire pour retrouver un état de surface approprié 347 à l'issue de cette opération.

Les étapes suivantes consistent à créer des tranchées étroites 350 qui bordent les motifs d'oxyde 337 dans la couche épitaxiale de silicium monocristallin. A ce stade on notera qu'il existe différents procédés pour retrouver après polissage les motifs enterrés de silicium poreux 30 recouverts par les motifs d'oxyde 337. Par exemple, à l'aide de marques d'alignement qui devront être dégagées. Le principe est de réaliser une photolithographie et une gravure des chemins de découpe permettant de retrouver les marques d'alignement du dernier niveau se trouvant enterré par la couche épitaxiale 345. Un alignement grossier est d'abord effectué à l'aide du méplat ou de l'entaille de positionnement qui existe sur chacune des tranches. Le dégagement de marques est alors réalisé. Dans un second temps, un alignement fin peut être effectué en utilisant les marques prévues à cet effet pour les niveaux suivants.

Les tranchées 350 sont ensuite comblées avec de l'oxyde et un dépôt est effectué qui couvre toute la surface de la tranche de façon à ce que les zones mobiles des MEMS 35 soient complètement enrobées par de l'oxyde 39. Un nouveau polissage de l'oxyde peut être nécessaire.

Le tout est recouvert comme précédemment par une couche 40 d'un matériau résistant à une attaque destinée à dissoudre l'oxyde enrobant les parties mobiles. Comme précédemment, et dans les mêmes conditions, une zone d'arrêt verticale pour limiter horizontalement la libération des parties mobiles pourra optionnellement aussi être créée 45. Des solutions d'attaque et des matériaux qui peuvent être employés ont déjà été cités dans la description de la figure 2.

Sont également identiques toutes les étapes suivantes jusqu'à libération des parties mobiles. Le transfert 51 sur une deuxième tranche 60 est fait dans les mêmes conditions qu'en figure 2 pour obtenir l'assemblage 65. Un amincissement 71 et un polissage de la face inférieure 70 sont réalisés pour faire apparaître les zones poreuses après quoi la libération 81 des parties mobiles peut se faire comme précédemment. Il est à noter qu'avec cette structure utilisant du silicium monocristallin la dissolution de l'oxyde est limitée latéralement par la couche épitaxiale et ne peut se faire que dans la mince couche d'oxyde supérieure de la couche sacrificielle 39 ce qui contribue à un meilleur contrôle de l'étape de libération des parties mobiles 80. La formation de zones d'arrêt 45 est optionnelle.

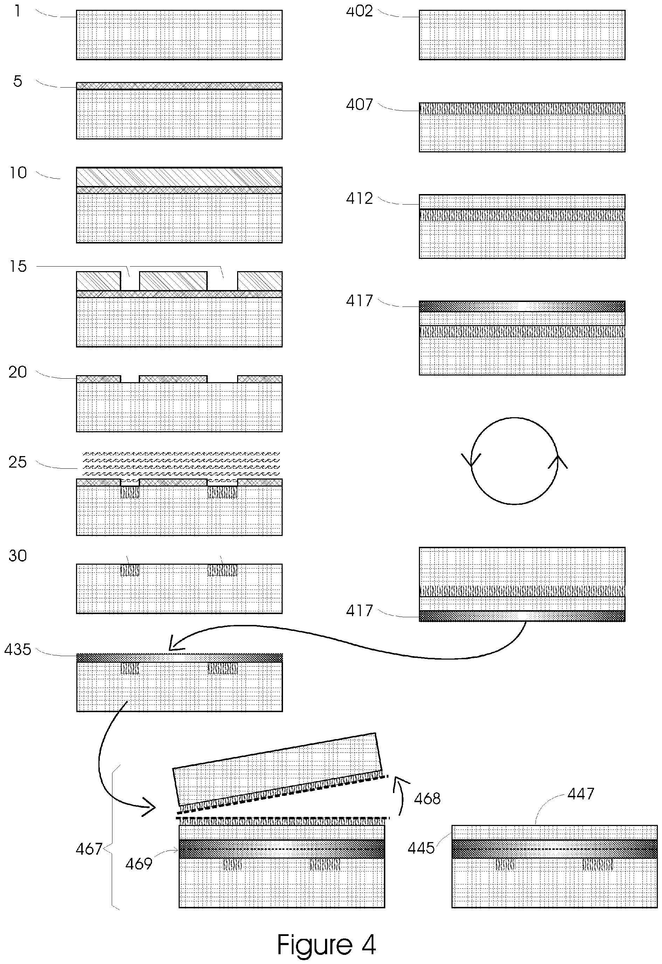

La **figure 4** illustre une variante de mise en oeuvre du procédé de l'invention qui permet aussi d'obtenir une couche de silicium monocristallin dans laquelle des dispositifs électroniques et des MEMS peuvent être avantageusement fabriqués simultanément. MEMS dont les parties mobiles seront libérées comme décrit en figure 2 et 3.

La méthode consiste ici à obtenir, comme précédemment, une première tranche de silicium monocristallin dans laquelle des zones poreuses ont été créées 30. Les étapes du procédé 1 à 30 qui conduisent à la formation de zones poreuses à la surface de la première tranche sont rigoureusement identiques à celles équivalentes de la figure 2 et ne sont pas autrement décrites.

Une deuxième tranche de silicium monocristallin 402, par exemple du même type que celle sur laquelle on a formé des zones poreuses, est utilisée. Une couche poreuse 407 est alors créée sur toute la surface de celle-ci. La formation de la couche poreuse se fait dans les mêmes conditions que celles décrites en figure 2 à l'exception du fait qu'aucune opération de lithographie et de gravure d'un matériau protecteur n'est nécessaire puisque le silicium poreux couvre cette fois toute la surface. Cette opération est suivie de la formation, par croissance épitaxiale, d'une couche de silicium monocristallin 412 à partir de la couche de silicium poreux 407. Les conditions d'épitaxie diffèrent toutefois de celles communément utilisées sur silicium massif. En particulier, une fois le silicium poreux réalisé, un premier traitement thermique sous vide est appliqué afin de stabiliser la morphologie du silicium poreux avant de réaliser une épitaxie.

Un dépôt d'oxyde de silicium est ensuite effectué sur toute la surface 417 en vue de l'assemblage, après retournement, avec la première tranche 1 sur laquelle des zones de silicium poreux ont été formées 30. La première tranche reçoit elle-même un dépôt d'oxyde sur toute sa surface 435 en vue du collage des deux tranches pour former un assemblage 467. Comme déjà discuté, on pourra faire appel, par exemple, à une technique de collage par adhésion moléculaire oxyde sur oxyde à basse température 469. D'autres méthodes sont connues de l'homme du métier et pourraient être aussi bien utilisées afin de réaliser l'assemblage des deux substrats.

Pour ne laisser en surface qu'une mince couche de silicium monocristallin dans laquelle pourront être réalisés des composants électroniques, notamment des circuits logiques ou analogiques, en même temps que des dispositifs MEMS il est connu de pouvoir réaliser une fracture 468 au niveau de la couche de silicium poreux de la deuxième tranche. La partie restante de la tranche pouvant alors être réutilisée.

Il est aussi possible de procéder par abrasion mécanique et chimique, par exemple en deux étapes comme décrit en figure 2. Un polissage de type CMP permet un arrêt de l'amincissement à détection de la fin de la zone poreuse.

Un polissage de type CMP doit être de toute façon pratiqué pour retrouver la couche épitaxiale de silicium monocristallin 445 et un bon état de surface 447 dans les deux cas. Pour permettre le positionnement des opérations suivantes les motifs enterrés de silicium poreux pourront se retrouver après polissage comme déjà décrit en référence à la figure 3.

A ce stade, l'assemblage des deux substrats est similaire à ce qui obtenu en figure 3 (345 et 347). Toutes les étapes qui suivent, à partir de l'étape 350, peuvent alors s'appliquer dans les mêmes conditions. La seule différence étant qu'il existe, avec cette structure de la figure 4, deux couches continues d'oxyde de silicium enrobant les parties mobiles (au lieu d'une seule avec la méthode décrite en figure 3). Le contrôle de la libération des parties mobiles n'en sera pas pour autant affecté significativement. Dans cette variante du deuxième mode de mise en oeuvre de l'invention décrit en figure 3, qui permet d'obtenir une couche de silicium monocristallin, trois tranches sont au total utilisées dont une peut être réutilisée.

L'invention atteint les objectives fixés en ne faisant cependant pas appel à des tranches élaborées de type SOI qui sont chères. Elle permet aussi que la libération des parties mobiles puisse se faire par la face inférieure ou arrière de la première tranche après que les composants électroniques et mécaniques soient protégés en raison de leur transfert sur la deuxième tranche. Deuxième tranche qui sert alors de support mécanique et qui constitue une protection très efficace pour tous les dispositifs déjà fabriqués à la surface de la première tranche.

## Revendications

1. Procédé de fabrication d'un microsystème électromécanique comportant des parties mécaniques mobiles, ledit procédé comprenant une phase de libération d'au moins une partie mécanique mobile, la phase de libération comportant les étapes suivantes:
formation d'au moins une zone poreuse (30) dans une première tranche (1) d'un matériau semi-conducteur;
formation d'au moins un motif d'un matériau apte à constituer au moins une partie mécanique mobile (35) sur une face avant de la première tranche (1) et enrobage au moins partiel du motif dans une couche sacrificielle (39) ;
libération (81) de la partie mécanique mobile par la face arrière de la première tranche (1) à travers la zone poreuse (30) à l'aide d'un solvant de la couche sacrificielle (39),
**caractérisé en ce que**, avant libération de la partie mécanique mobile, on effectue :
un transfert (51) par collage par la face avant de la première tranche (1) sur une deuxième tranche (60);
un amincissement (71) à partir de la face arrière de la première tranche (1) jusqu'à détection (70) de la zone poreuse (30)..

2. Procédé selon la revendication 1 dans lequel on dépose, au dessus de la couche sacrificielle (39), une couche (40) d'un matériau résistant à une attaque par un solvant de la couche sacrificielle (39).

3. Procédé selon l'une des revendications précédentes, dans lequel l'enrobage comprend un dépôt du matériau de la couche sacrificielle qui couvre toute la surface de la première tranche.

4. Procédé selon l'une des revendications précédentes dans lequel la couche sacrificielle (39) couvre au moins partiellement la zone poreuse (30).

5. Procédé selon la revendication précédente dans lequel on interrompt la couche sacrificielle (39) par au moins une barrière (45) apte à délimiter au moins partiellement une zone à libérer autour de la partie mécanique mobile, ladite barrière (45) étant faite d'un matériau résistant à une attaque par un solvant de la couche sacrificielle.

6. Procédé selon l'une des revendications précédentes dans lequel la couche sacrificielle (39) est faite d'un oxyde du matériau semi-conducteur constituant la première tranche (1).

7. Procédé selon l'une des revendications précédentes dans lequel le matériau apte à constituer le motif de la partie mécanique est du silicium monocristallin.

8. Procédé selon la revendication précédente dans lequel le silicium monocristallin (345) du motif est obtenu par croissance épitaxiale sélective à partir de la première tranche (1) elle-même constituée de silicium monocristallin.

9. Procédé selon la revendication précédente dans lequel on forme au moins un motif d'oxyde (337) sur la zone poreuse (30), ledit motif d'oxyde (337) faisant partie de la couche sacrificielle (39), et on opère la croissance épitaxiale de sorte à recouvrir le motif d'oxyde (337).

10. Procédé selon la revendication 6 dans lequel le silicium monocristallin (445) du motif est obtenu par transfert d'une couche épitaxiale (412) formée sur une troisième tranche de silicium monocristallin (402) après formation d'une couche de silicium poreux (407) à sa surface.

11. Procédé selon la revendication précédente dans lequel un dépôt d'une couche d'oxyde (435) sur la première tranche à l'issue de la formation de la zone poreuse (30) et un dépôt d'oxyde (417) sur la troisième tranche à l'issue de la formation de la couche épitaxiale (412) sont effectués en vue de leur assemblage par collage (469).

12. Procédé selon la revendication précédente comportant une étape de fracturation (468) de la troisième tranche au niveau de la couche de silicium poreux (407) et une étape de polissage afin de laisser à la surface de la première tranche (1), une couche continue de silicium monocristallin (445).

13. Procédé selon l'une des revendications 8 ou 10 ou 11 dans lequel on forme au moins une tranchée (350) remplie d'oxyde au droit de la zone poreuse (30), suivi par un dépôt d'oxyde sur toute la surface de la première tranche afin de constituer, avec le motif (337) ou la couche d'oxyde (435) préalablement formé sur la zone poreuse (30), la couche sacrificielle (39) enrobant la partie mécanique mobile.

14. Procédé selon l'une des revendications 7 à 12 comportant la réalisation d'au moins un composant électronique du microsystème électromécanique dans la couche de silicium monocristallin (345, 445).

15. Procédé selon l'une des revendications 1 à 5 dans lequel le matériau apte à constituer le motif de la partie mécanique mobile est du silicium polycristallin.

16. Procédé selon l'une des revendications précédentes comprenant la réalisation (250) d'étapes de fabrication de composants électroniques participant au microsystème électromécanique au-dessus de la couche (40) d'un matériau résistant à une attaque par un solvant de la couche sacrificielle (39).

17. Procédé selon l'une des revendications précédentes comprenant une étape de dépôt sur une face arrière opposée à la face avant de la première tranche d'un matériau apte à rendre étanche le microsystème électromécanique par obstruction de la zone poreuse (30).

18. Procédé selon l'une des revendications précédentes dans lequel on forme plusieurs zones poreuses (30) et/ ou plusieurs motifs de parties mécaniques mobiles.

19. Dispositif de réalisation d'un microsystème électromécanique comprenant en superposition surune première tranche (1) d'un matériau semi-conducteur, une couche sacrificielle (39) et une couche (40) d'un matériau résistant à une attaque par un solvant de la couche sacrificielle (39), et comprenant en outre au moins une partie mécanique mobile au moins partiellement enrobée dans la couche sacrificielle (39), le dispositif comportant au moins une zone poreuse formée dans la première tranche (1) et traversant l'épaisseur de ladite première tranche (1) jusqu'à sa face arrière pour permettre un accès fluidique vers la couche sacrificielle (39), **caractérisé en ce qu'**il comporte une deuxième tranche collée sur la première tranche (1) par la face avant de la première tranche (1).

20. Microsystème électromécanique comprenant une première tranche (1) d'un matériau semi-conducteur et une couche (40) délimitant une chambre de logement d'au moins une partie mécanique mobile, comportant au moins une zone poreuse formée dans la première tranche (1) et traversant l'épaisseur de ladite tranche (1) pour permettre un accès fluidique vers la chambre **caractérisé en ce qu'**il comporte une deuxième tranche collée sur la première tranche (1) par la face avant de la première tranche (1).

## Patentansprüche

1. Herstellungsverfahren für ein mikroelektromechanisches Bauelement, mobile mechanische Abschnitte umfassend, wobei das besagte Verfahren eine Freilegungsphase zumindest eines mobilen mechanischen Abschnitts umfasst, wobei die Freilegungsphase die folgenden Schritte umfasst:
Bildung zumindest einer porösen Schicht (30) auf zumindest einer Halbleiterscheibe (1) aus einem Halbleitermaterial;
Bildung zumindest eines Motivs aus einem Material, das imstande ist, zumindest einen mobilen mechanischen Abschnitt (35) auf einer Vorderseite der ersten Halbleiterscheibe (1) zu bilden, sowie eine zumindest teilweise Umhüllung des Motivs auf einer Opferschicht (39);
Freilegung (81) des mobilen mechanischen Abschnitts über die Rückseite der ersten Halbleiterscheibe (1) durch die poröse Schicht (30) hindurch, mithilfe eines Lösungsmittels der Opferschicht (39),
**dadurch gekennzeichnet, dass** man vor der Freilegung des mobilen mechanischen Abschnitts Folgendes durchführt:
einen Transfer (51) durch Verkleben über die Vorderseite der ersten Halbleiterscheibe (1) auf einer zweiten Halbleiterscheibe (60);
Verjüngung (71) ab der Rückseite der ersten Halbleiterscheibe (1) bis zur Erfassung (70) der porösen Schicht (30).

2. Verfahren nach Anspruch 1, wobei man über der Opferschicht (39) eine Schicht (40) eines Materials aufträgt, das einem Angriff durch ein Lösungsmittel der Opferschicht (39) standhält.

3. Verfahren nach einem der vorhergehenden Ansprüche, wobei die Umhüllung eine Ablagerung des Materials der Opferschicht umfasst, das die gesamte Oberfläche der ersten Halbleiterscheibe abdeckt.

4. Verfahren nach einem der vorhergehenden Ansprüche, wobei die Opferschicht (39) zumindest teilweise die poröse Schicht (30) abdeckt.

5. Verfahren nach dem vorhergehenden Anspruch, wobei man die Opferschicht (39) durch zumindest eine Barriere (45) unterbricht, die imstande ist, zumindest teilweise eine freizulegende Schicht um den mobilen mechanischen Abschnitt einzugrenzen, wobei die besagte Barriere (45) aus einem Material gefertigt ist, das einem Angriff durch ein Lösungsmittel der Opferschicht standhält.

6. Verfahren nach einem der vorhergehenden Ansprüche, wobei die Opferschicht (39) aus einem Oxid des Halbleitermaterials gefertigt ist, welches die erste Halbleiterscheibe (1) bildet.

7. Verfahren nach einem der vorhergehenden Ansprüche, wobei das Material, das imstande ist, das Motiv des mechanischen Abschnitts zu bilden, Einkristall-Siliziummaterial ist.

8. Verfahren nach dem vorhergehenden Anspruch, wobei man das Einkristall-Siliziummaterial (345) des Motivs durch selektives epitaktisches Wachstum aus der ersten Halbleiterscheibe (1) erhält, die selbst aus Einkristall-Siliziummaterial gebildet wird.

9. Verfahren nach dem vorhergehenden Anspruch, wobei man zumindest ein Oxidmotiv (337) auf der porösen Schicht (30) bildet, wobei das besagte Oxidmotiv (337) zur Opferschicht (39) gehört, und man das epitaktische Wachstum vornimmt, um das Oxidmotiv (337) abzudecken.

10. Verfahren nach Anspruch 6, wobei man das Einkristall-Siliziummaterial des Motivs (445) durch den Transfer einer epitaktischen Schicht (412) erhält, die auf einer dritten Halbleiterscheibe aus Einkristall-Siliziummaterial (402) nach der Bildung einer porösen Siliziumschicht (407) auf ihrer Oberfläche gebildet wird.

11. Verfahren nach dem vorhergehenden Anspruch, wobei eine Ablagerung einer Oxidschicht (435) auf der ersten Halbleiterscheibe nach der Bildung der porösen Schicht (30), und eine Ablagerung von Oxid (417) auf der dritten Halbleiterscheibe nach der Bildung der epitaktischen Schicht (412) durchgeführt werden, um durch Verkleben (469) miteinander verbunden zu werden.

12. Verfahren nach dem vorhergehenden Anspruch, einen Schritt zum Aufbrechen (468) der dritten Halbleiterscheibe im Bereich der porösen Siliziumschicht (407) und einen Schritt zum Polieren umfassend, um auf der Oberfläche der ersten Halbleiterscheibe (1) eine durchgehende Schicht an Einkristall-Siliziummaterial (445) zu belassen.

13. Verfahren nach einem der Ansprüche 8 oder 10 oder 11, wobei man zumindest einen Graben (350) bildet, der auf Höhe der porösen Schicht (30) mit Oxid gefüllt ist, gefolgt von einer Ablagerung von Oxid auf der gesamten Oberfläche der ersten Halbleiterscheibe, um mit dem zuvor auf der porösen Schicht (30) gebildeten Motiv (337) oder der Oxidschicht (435) die Opferschicht (39) zu bilden, welche den mobilen mechanischen Abschnitt umhüllt.

14. Verfahren nach einem der Ansprüche 7 bis 12, die Herstellung zumindest eines elektronischen Bauteils des mikroelektromechanischen Bauelements auf der Schicht aus Einkristall-Siliziummaterial (345, 445) umfassend.

15. Verfahren nach einem der Ansprüche 1 bis 5, wobei das Material, das imstande ist, das Motiv des mobilen mechanischen Abschnitts zu bilden, ein Mehrkristall-Siliziummaterial ist.

16. Verfahren nach einem der vorhergehenden Ansprüche, die Durchführung (250) von Herstellungsschritten von elektronischen Bauteilen umfassend, die am mikroelektromechanischen Bauelement teilhaben, über der Schicht (40) aus einem Material, das einem Angriff durch ein Lösungsmittel der Opferschicht (39) standhält.

17. Verfahren nach einem der vorhergehenden Ansprüche, einen Schritt zur Ablagerung auf einer Rückseite, gegenüber der Vorderseite der ersten Halbleiterscheibe aus einem Material umfassend, das imstande ist, das mikroelektromechanische Bauelement durch Verschließen der porösen Schicht (30) abzudichten.

18. Verfahren nach einem der vorhergehenden Ansprüche, wobei man mehrere poröse Schichten (30) und/ oder mehrere Motive mobiler mechanischer Abschnitte bildet.

19. Vorrichtung zur Herstellung eines mikroelektromechanischen Bauelements, eine Überlagerung auf einer ersten Halbleiterscheibe (1) aus einem Halbleitermaterial, einer Opferschicht (39), einer Schicht (40) aus einem Material, das einem Angriff durch ein Lösungsmittel der Opferschicht (39) standhält, umfassend, und darüber hinaus zumindest einen mobilen mechanischen Abschnitt umfassend, der zumindest teilweise in der Opferschicht (39) umhüllt ist, wobei die Vorrichtung zumindest eine poröse Schicht umfasst, die auf der ersten Halbleiterscheibe (1) gebildet wird, und durch die Dicke der besagten ersten Halbleiterscheibe (1) bis zu ihrer Rückseite hindurchführt, um einen Fluidzugang zur Opferschicht (39) zu ermöglichen, **dadurch gekennzeichnet, dass** sie eine zweite Halbleiterscheibe umfasst, die über die Vorderseite der ersten Halbleiterscheibe (1) auf die erste Halbleiterscheibe (1) geklebt ist.

20. Mikroelektromechanisches Bauelement, eine erste Halbleiterscheibe (1) aus einem Halbleitermaterial und eine Schicht (40) umfassend, die eine Aufnahmekammer für zumindest einen mobilen mechanischen Abschnitt eingrenzt, zumindest eine poröse Schicht umfassend, die auf der ersten Halbleiterscheibe (1) gebildet wird, und durch die Dicke der besagten ersten Halbleiterscheibe (1) hindurchführt, um einen Fluidzugang zur Kammer zu ermöglichen, **dadurch gekennzeichnet, dass** es eine zweite Halbleiterscheibe umfasst, die über die Vorderseite der ersten Halbleiterscheibe (1) auf die erste Halbleiterscheibe (1) geklebt ist.

## Claims

1. A method for producing an electro-mechanical microsystem including movable mechanical parts, said method including a phase of releasing at least one movable mechanical part, the releasing phase including the following steps:
formation of at least one porous zone (30) in a first wafer (1) of a semiconductor material ;
formation of at least a pattern of a material suitable for making at least one movable mechanical part (35) on a front face of the first wafer (1) and at least a partial encapsulation of the pattern in a sacrificial layer (39) ;
release (81) of the movable mechanical part through the rear face of the first wafer (1) throughout the porous zone (30), using a solvent of the sacrificial layer (39),
**characterized in that** prior to releasing the movable mechanical part:
a transfer (51) by bonding the front face of the first wafer (1) onto a second wafer (60);
a thinning (71) from the rear face of the first wafer (1) until the porous zone (30) is detected (70),
are executed.

2. A method according to claim 1, wherein a layer (40) of a material withstanding an attack by a solvent of the sacrificial layer (39) is deposited above the sacrificial layer (39).

3. A method according to one of the preceding claims wherein the encapsulation comprises a deposition of the material of the sacrificial layer which covers the entire surface of the first wafer.

4. A method according to one of the preceding claims, wherein the sacrificial layer (39) covers at least partially the porous zone (30).

5. A method according to the preceding claim, wherein the sacrificial layer (39) is interrupted by at least one barrier (45) able to define at least partially one zone to be released about the movable mechanical part, said barrier (45) being made of a material withstanding an attack by a solvent of the sacrificial layer.

6. A method according to one of the preceding claims, wherein the sacrificial layer (39) is made of an oxide of the semiconductor material making up the first wafer (1).

7. A method according to one of the preceding claims, wherein the material suitable for making the pattern of the mechanical part is monocrystalline silicon.

8. A method according to the preceding claim, wherein the monocrystalline silicon (345) of the pattern is obtained by a selective epitaxial growth from the first wafer (1), which is also made up of monocrystalline silicon.

9. A method according to the preceding claim, wherein at least one oxide pattern (337) is formed on the porous zone (30), said oxide pattern (337) belonging to the sacrificial layer (39), and the epitaxial growth is so executed as to cover the oxide pattern (337).

10. A method according to claim 6, wherein the monocrystalline silicon (445) of the pattern is obtained by transfer of an epitaxial layer (412) formed on a third wafer of monocrystalline silicon (402) after the formation of a layer of porous silicon (407) on the surface thereof.

11. A method according to the preceding claim, wherein a deposition of an oxide layer (435) is made on the first wafer upon completion of the formation of the porous zone (30) and a deposition of oxide (417) is made on the third wafer upon completion of the formation of the epitaxial layer (412) for the assembling thereof by bonding (469).

12. A method according to the preceding claim, including a step of fracturing (468) the third wafer at the level of the layer of porous silicon (407) and a step of polishing, so as to leave a continuous layer of monocrystalline silicon (445) at the surface of the first wafer (1).

13. A method according to one of claims 8 or 10 or 11, wherein at least one trench (350) filled with oxide is formed orthogonally to the porous zone (30), followed by a deposition of oxide on the whole surface of the first wafer so as to make up, with the pattern (337) or the layer of oxide (435) previously formed on the porous zone (30), the sacrificial layer (39) encapsulating the movable mechanical part.

14. A method according to claims 7 to 12 including the production of at least one electronic component of the electro-mechanical microsystem in the layer of monocrystalline silicon (345, 445).

15. A method according to one of claims 1 to 5, wherein the material able to make up the pattern of the movable mechanical part is polycrystalline silicon.

16. A method according to one of the preceding claims, including the execution (250) of steps of production of electronic components participating in the electro-mechanical microsystem above the layer (40) of a material withstanding an attack by a solvent of the sacrificial layer (39).

17. A method according to one of the preceding claims, including a step of deposition onto a rear face opposite the front face of the first wafer of a material able to make the electro-mechanical microsystem tight by obstruction of the porous zone (30).

18. A method according to one of the preceding claims, wherein several porous zones (30) and / or several patterns of movable mechanical parts are formed.

19. A method for producing an electro-mechanical microsystem including a superposition on a first wafer (1) of a semiconductor material, a sacrificial layer (39) and a layer (40) of a material withstanding an attack by a solvent of the sacrificial layer (39), and further including one movable mechanical part at least partially encapsulated in the sacrificial layer (39), the method comprising at least one porous zone is formed in the first wafer (1) going through the thickness of said first wafer (1) until its rear face to enable a fluid access to the sacrificial layer (39) **characterized in that** it comprises a second wafer bonding on the first wafer (1) by the front face of the first wafer (1).

20. An electro-mechanical microsystem including a first wafer (1) made of a semiconductor material and a layer (40) defining a housing chamber of at least one movable mechanical part, including at least one porous zone formed in the first wafer (1) and going through the thickness of said wafer (1) to enable a fluid access to the chamber **characterized in that** it comprises a second wafer bonding on the first wafer (1) by the front face of the first wafer (1).
